# EUROPEAN PATENT APPLICATION

(11) **EP 4 598 328 A1**
(43) Date of publication of application: **06.08.2025**
(21) Application number: 23872077.5
(22) Date of filing: 20.09.2023
(51) Int. Cl.: H10N 30/50, C04B 35/495, H10N 30/053, H10N 30/093, H10N 30/097, H10N 30/20, H10N 30/853

(54) **LEAD-FREE PIEZOELECTRIC COMPOSITION AND PIEZOELECTRIC ELEMENT**

(30) Priority: 30.09.2022 JP 2022158310
(71) Applicant: Niterra Co., Ltd., Nagoya-shi, Aichi 461-0005 (JP)
(72) Inventor: HIROSE, Yoshinobu, Nagoya-shi, Aichi 461-0005 (JP); ICHIHASHI, Kentaro, Nagoya-shi, Aichi 461-0005 (JP); NISHI, Tomohiro, Nagoya-shi, Aichi 461-0005 (JP); YAMAZAKI, Masato, Nagoya-shi, Aichi 461-0005 (JP)
(74) Representative: Grünecker Patent- und Rechtsanwälte PartG mbB
(86) International application number: PCT/JP2023/034101
(87) International publication number: WO 2024/070849

(57) **Abstract**

A lead-free piezoelectric composition according to the present invention comprises a main phase containing an alkali niobate perovskite oxide, and a sub-phase containing an Mn oxide, the Mn oxide containing 0.05-5 mol% inclusive of Sc.

## Description

### TECHNICAL FIELD

The present invention relates to a lead-free piezoelectric composition and to a piezoelectric element.

### BACKGROUND ART

Hitherto, many piezoelectric elements have been formed of a PZT (lead zirconate titanate) material. However, a lead component contained in PZT evokes a problematic impact on the environment. Thus, in recent years, development of piezoelectric elements formed of a lead-free material has been pursued.

As one example of such a lead-free material, there has been proposed a lead-free piezoelectric composition containing a primary phase which is a first crystalline phase formed of an alkali niobate perovskite-type oxide, and a secondary phase containing second crystals formed of an M-Ti-O spinel compound (in which element M represents a monovalent to tetravalent element) (see Patent Document 1).

The alkali niobate perovskite-type oxide forming the primary phase *per se* is a substance in which voids are readily provided, and the voids impair piezoelectric characteristics. By filling the voids in the primary phase with the secondary phase containing second crystals, the structure of the primary phase (first crystalline phase) is stabilized. Thus, the aforementioned lead-free piezoelectric composition is excellent in piezoelectric characteristics. Specifically, when force is applied to the lead-free piezoelectric composition, voltage is generated, whereas when voltage is applied, the lead-free piezoelectric composition undergoes dimensional contraction and change in shape.

Also, as disclosed in Patent Literature 2, there has been known, as a piezoelectric element, a laminate-type piezoelectric element having a stacked body in which inner electrodes mainly formed of Ni and a lead-free piezoelectric ceramic layers are alternatingly stacked. In such a laminate-type piezoelectric element, the inner electrodes are formed of Ni as a material (a main component) for attaining low cost.

### CITATION LIST

### PATENT LITERATURE

Patent Literature 1: JP 5715309B
Patent Literature 2: JP 5862983B

### (Problems to be Solved by the Invention)

Although the aforementioned lead-free piezoelectric composition is excellent in piezoelectric characteristics, the insulation property at high temperature (e.g., 100°C) is problematically low. More specifically, although the properties including insulation property of the aforementioned laminate-type piezoelectric element must satisfy high reliability, the insulation property at high temperature (e.g., 100°C) is problematically low.

### SUMMARY OF INVENTION

An object of the present invention is to provide a lead-free piezoelectric composition which is excellent in piezoelectric characteristics and insulation property at high temperature, and the like.

### (Means for Solving the Problems)

The means for solving the aforementioned problem is as follows.
<1> A lead-free piezoelectric composition having a primary phase containing an alkali niobate perovskite-type oxide and a secondary phase containing an Mn oxide, in which the Mn oxide contains Sc in an amount of 0.05 mol% or more and 5 mol% or less.
<2> The lead-free piezoelectric composition according to <1> above, in which the Mn oxide includes at least one species of Mn₄Nb₂O₉, MnTi₂O₄, and Mn₂TiO₄.
<3> The lead-free piezoelectric composition according to <1> or <2> above, in which crystal grains of the secondary phase has a maximum mean grain size of 94 µm or smaller.
<4> A piezoelectric element having a structure in which a lead-free piezoelectric composition as recited in any one of <1> to <3> above, and an electrode are alternatingly stacked.

### (Advantageous Effects of the Invention)

According to the present invention, a lead-free piezoelectric composition which is excellent in piezoelectric characteristics and insulation property at high temperature, and the like can be provided.

### BRIEF DESCRIPTION OF DRAWINGS

[FIG. 1] Perspective view of a piezoelectric element of embodiment 1.
[FIG. 2] Cross-section of a piezoelectric element of embodiment 2.

### DESCRIPTION OF EMBODIMENTS

Hereinafter, the lead-free piezoelectric composition and the piezoelectric element according to an embodiment will be described.

The lead-free piezoelectric composition has a primary phase containing an alkali niobate perovskite-type oxide and a secondary phase containing an Mn oxide.

The primary phase is formed of a first crystalline phase formed of an alkali niobate perovskite-type oxide. The alkali niobate perovskite-type oxide is represented by the following compositional formula (1).

(A1ₐM1_{b})_{c}(Nb_{d1}Mn_{d2}Ti_{d3}Zr_{d4})O₃₊ₑ ··· (1)

The element A1 is an alkali metal which is at least one species of Li, Na, and K. The element M1 is an alkaline earth metal which is at least one species of Ba (barium), Ca (calcium), and Sr (strontium).

In the above compositional formula (1), the element A1 and the element M1 are disposed in A sites of the perovskite structure, and Nb (niobium), Mn (manganese), Ti (titanium), and Zr (zirconium) are disposed in B sites.

In the compositional formula (1), coefficients a to e are selected from the values which are preferred from the viewpoints of electrical characteristics and piezoelectric characteristics (in particular, piezoelectric constant d₃₃) of the lead-free piezoelectric composition, so long as the coefficients a to e ensure establishment of the perovskite structure.

Specifically, coefficients a and b satisfy the conditions: 0<a<1, 0<b<1, and a+b=1. However, the cases of a=0 (i.e., the composition containing no alkali metal) and b=0 (i.e., the composition containing none of Ca, Sr, and Ba) are excluded.

Coefficient c with respect to the entire A sites satisfies 0.80<c<1.10, and is preferably 0. 84≤c≤1.08, more preferably 0.88≤c≤1.07.

Coefficients d1, d2, d3, and d4 satisfy the conditions: 0<d1<1, 0<d2<1, 0<d3<1, 0≤d4<1, and d1+d2+d3+d4=1. However, the cases of d1=0 (i.e., the composition containing no Nb), d2=0 (i.e., the composition containing no Mn), and d3=0 (i.e., the composition containing no Ti or Zr) are excluded. Coefficient d4 to Zr may be 0 (i.e., any composition containing no Zr being acceptable).

In coefficient (3+e) with respect to oxygen, the value of e is a positive or negative value showing deficiency or excess from the intrinsic value of 3 with respect to oxygen. Coefficient (3+e) with respect to oxygen may be a value which allows the primary phase to have a perovskite oxide structure. Typically, coefficient e is 0, and preferably satisfies 0≤e≤0.1. Notably, coefficient e may also be calculated from the composition of the primary phase to meet the electrically neutral condition. However, needless to say, a composition of the primary phase which is slightly deviated from the electrically neutral condition is also allowable.

Among the alkali niobate perovskite-type oxides represented by the aforementioned compositional formula (1), those containing K, Na, and Nb as main metallic components are called "KNN" or "KNN material" and exhibit excellent properties such as piezoelectric and electric characteristics.

Notably, the aforementioned compositional formula (1) can be transformed into the following compositional formula (1A).

(Kₐ₁Naₐ₂Liₐ₃Ca_{b1}Sr_{b2}Ba_{b3})_{c}(Nb_{d1}Mn_{d2}Ti_{d3}Zr_{d4})O₃₊ₑ ··· (1A)

The aforementioned compositional formula (1) is equivalent to the above formula (1A), and the conditions: a1+a2+a3=a and b1+b2+b3=b are satisfied. Coefficients a1 and a2 with respect to K and Na satisfy the conditions: 0<a1≤0.6 and 0<a1≤0.6, respectively. Coefficient a3 with respect to Li is 0≤a3≤0.2 (preferably 0≤a3≤0.1).

The secondary phase is formed of a second crystalline phase containing an Mn oxide. The Mn oxide is an oxide containing Mn (manganese) and Sc (scandium) in an amount of 0.05 mol% or more and 5 mol% or less. The method for determining the Sc content (mol%) of the secondary phase will be described below.

Notably, when the Mn oxide includes Mn₂TiO₄, the Mn oxide preferably contains Sc in an amount of 0.05 mol% or more and 1 mol% or less.

Examples of the Mn oxide include Mn₄Nb₂O₉, MnTi₂O₄, and Mn₂TiO₄. The Mn oxide preferably includes at least one species of, for example, Mn₄Nb₂O₉, MnTi₂O₄, and Mn₂TiO₄.

In the case where the Mn oxide is an Mn-Ti-O oxide, the coefficients in the aforementioned compositional formulas (MnTi₂O₄, Mn₂TiO₄) may be deviated from the standard values, so long as the Mn-Ti-O oxide maintains a spinel-type structure, and variation in characteristics of the compound is acceptable. For example, compositions represented by the following formulas (2) and (3) may be accepted. Notably, the Mn-Ti-O oxides represented by the following formulas (2) and (3) may contain impurity elements such as Na, K, Nb, Zr, Ba, Ca, Sr, Sc, and Ni.

MnₐTi_{2b}O_{4±e} ... (2)

Mn_{2c}Ti_{d}O_{4±e} ··· (3)

In the above compositional formula (2), conditions: 0.8<a<1.2 and 0.8<b<1.2 are satisfied, and e is a value representing the deficiency or excess of oxygen. Also, in the above compositional formula (3), conditions: 0.8<c<1.2 and 0.8<d<1.2 are satisfied, and e is a value representing the deficiency or excess of oxygen.

In the case where the Mn oxide is an Mn-Nb-O oxide, the coefficients in the aforementioned compositional formula (Mn₄Nb₂O₉) may be deviated from the standard values, so long as the Mn-Nb-O oxide maintains a spinel-type structure, and variation in characteristics of the compound is acceptable. For example, a composition represented by the following formula (4) may be accepted. Notably, the Mn-Nb-O oxides represented by the following formula (4) may contain impurity elements such as Na, K, Ti, Zr, Ba, Ca, Sr, Sc, and Ni.

Mn_{4f}Nb_{2g}O_{9±h} ... (4)

In the above compositional formula (4), conditions: 0.8<f<1.2 and 0.8<g<1.2 are satisfied, and h is a value representing the deficiency or excess of oxygen.

Conceivably, Sc forms a solid solution with the secondary phase (a second crystalline phase). Sc is thought to occupy a part of the main metal element sites in the crystal structure of the Mn oxide.

For example, when the Mn oxide is Mn₄Nb₂O₉, Sc is conceivably present at a part of Mn (manganese) sites or a part of Nb (niobium) sites. When the Mn oxide is MnTi₂O₄, Sc is conceivably present at a part of Mn (manganese) sites or a part of Ti (titanium) sites.

In the lead-free piezoelectric composition of the present embodiment, the maximum grain size of the crystal grains in the secondary phase is preferably 94 µm or smaller. No particular limitation is imposed on the lower limit of the maximum grain size, so long as the object of the present invention is not impaired. The lower limit is preferably, for example, 0.8 µm or greater.

Also in the lead-free piezoelectric composition of the present embodiment, the number-basis 80% cumulative particle size (D80) of the crystal grains in the secondary phase is preferably 83 µm or smaller. No particular limitation is imposed on the lower limit of the D80, so long as the object of the present invention is not impaired. The lower limit is preferably, for example, 0.6 µm or greater.

In the lead-free piezoelectric composition of the present embodiment, the mean grain size of the crystal grains in the secondary phase is preferably 65 µm or smaller. No particular limitation is imposed on the lower limit of the mean grain size, so long as the object of the present invention is not impaired. The lower limit is preferably, for example, 0.4 µm or greater.

The maximum grain size, number-basis 80% cumulative particle size (D80), and mean grain size of the crystal grains of the secondary phase are determined through the methods mentioned below.

So long as the object of the present invention is not impaired, the lead-free piezoelectric composition of the present embodiment may include, as a secondary phase, two or more Mn oxides.

Also, so long as the object of the present invention is not impaired, the lead-free piezoelectric composition of the present embodiment may include, as a secondary phase, an additional crystalline phase (e.g., a third crystalline phase) other than the second crystalline phase containing Mn oxide.

The secondary phase including the second crystalline phase satisfying the above conditions is provided in a dispersed manner in the primary phase formed of the first crystalline phase. The secondary phase buries the voids (space) provided between minute crystals of the primary phase. Although the secondary phase has no piezoelectric characteristic, the co-presence of the secondary phase with the primary phase results in improvement in sinterability and structural stability as well as insulation property of the lead-free piezoelectric composition.

In the present embodiment, no particular limitation is imposed on the relative amount of the secondary phase in the lead-free piezoelectric composition, so long as the object of the present invention is not impaired. The secondary phase content is preferably, for example, 0.5 vol.% or more and 5 vol.% or less.

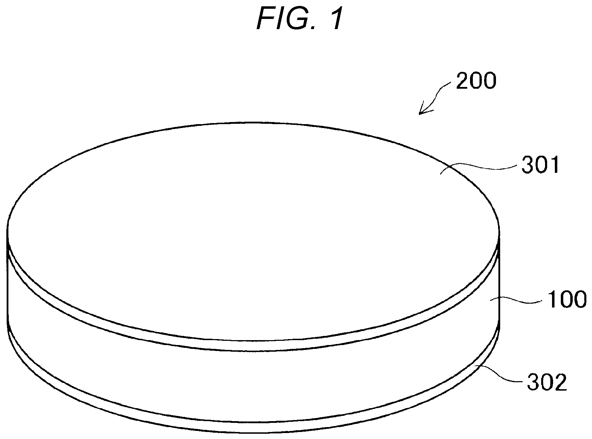

Next, a piezoelectric element 200 according to embodiment 1 will be described, with reference to FIG. 1. FIG. 1 is a perspective view of a piezoelectric element 200 of embodiment 1. As shown in FIG. 1, the piezoelectric element 200 of the present embodiment has a disk shape in appearance, and includes a disk-shape piezoelectric layer (an example of the piezoelectric ceramic layer) 100, an electrode 301 disposed on one surface of the piezoelectric layer 100, and an electrode 302 disposed on the other surface. The piezoelectric layer 100 is formed from the aforementioned lead-free piezoelectric composition. The piezoelectric layer 100 is polarized toward the thickness direction. The electrodes 301, 302 are formed of, for example, Au.

An example of the method of producing the aforementioned piezoelectric element 200 according to embodiment 1 will next be described. First, a plurality of essential ingredients for producing a primary phase are chosen from powder-form raw materials, and weighed so as to attain a target composition. The powder-form raw materials may be an oxide, a carbonate salt, a hydroxide, or the like of an element forming the primary phase. To the thus-weighed powder raw materials, ethanol is added, and the mixture is subjected to wet mixing by means of a ball mill preferably for 15 hours or longer, to thereby yield a slurry. The thus-obtained slurry was dried to form a powder mixture, and the powder is calcined under the conditions, for example, 600 to 1,000°C in air for 1 to 10 hours, to thereby obtain a powder-form primary phase calcined product.

Separately, a plurality of essential ingredients for producing the secondary phase are chosen from powder-form raw materials, and weighed so as to attain a target composition. In this case, a compound containing Mn and a compound containing Sc are used as essential powder-form raw materials. Regarding the powder-form raw material formed of an Sc-containing compound, the amount of addition is adjusted so that the Sc content of the secondary phase is controlled to 0.05 mol% to 5 mol%. Notably, the powder-form raw materials may be an oxide, a carbonate salt, a hydroxide, or the like of an element forming the secondary phase. To the thus-weighed powder-form raw materials, ethanol is added, and the mixture is subjected to wet mixing by means of a ball mill for preferably 15 hours or longer, to thereby prepare a slurry. The thus-prepared slurry is dried, and the dry powder mixture is calcined at, for example, 600 to 1,000°C in air for 1 to 10 hours, to thereby yield a secondary phase calcined product.

Subsequently, the primary phase calcined product and the secondary phase calcined product are mixed with a dispersant, a binder and ethanol, and the mixture is pulverized and mixed, to thereby give a slurry. The thus-obtained slurry is dried, and the product is suitably granulated and monoaxially pressed at a pressure, for example, 20 MPa, to thereby provide a preliminary compact of a disk shape. The thus-obtained preliminary compact is subjected to a cold isostatic pressing (CIP) treatment at, for example, 150 MPa, to thereby yield a compact.

Then, the thus-obtained compact is maintained at, for example, 200 to 400°C for 2 to 10 hours, to thereby effect debinding. The thus-debindered compact is fired at, for example, 1,000 to 1,200°C in a pressure-controlled reducing atmosphere (a pressure controlled to a reduction side from Ni/NO equilibrium oxygen partial pressure by order of 1 or greater) for 2 to 5 hours, to thereby form a piezoelectric layer.

On each surface of the formed piezoelectric layer, an Au electrode is formed through, for example, sputtering. Subsequently, the stacked body having the piezoelectric layer equipped with the electrodes is placed in silicone oil at 50°C and subjected to polarization treatment by applying a DC voltage of 5 kv/mm, to thereby generate a voltage characteristic of the piezoelectric layer. Thus, the piezoelectric element 200 is yielded.

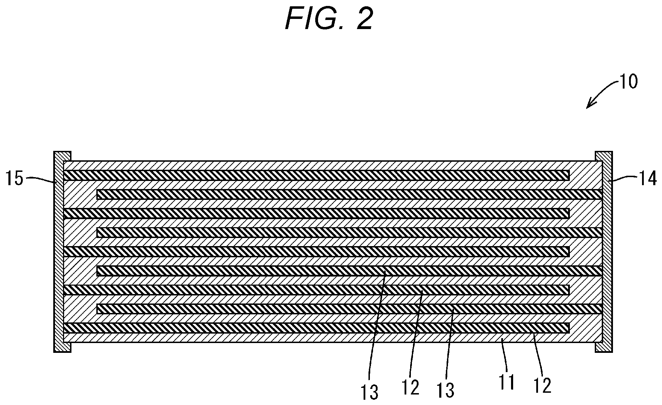

With reference to FIG. 2, a piezoelectric element 10 according to embodiment 2 will next be described in detail. FIG. 2 is a cross-section of the piezoelectric element 10 according to embodiment 2. As shown in FIG. 2, the piezoelectric element 10 of the present embodiment has a piezoelectric layer (an example of the voltage ceramic layer) 11, a plurality of inner electrodes 12, 13 which are in contact with the piezoelectric layer 11, and two outer electrodes 14, 15 which are connected to the inner electrodes 12, 13. The piezoelectric layer 11 is formed of the aforementioned lead-free piezoelectric composition. The inner electrodes 12, 13 are predominantly formed of a base metal (e.g., nickel). The piezoelectric layer 11 and the inner electrodes 12, 13 are alternatingly stacked. More specifically, the piezoelectric layer 11 and the inner electrodes 12, 13 are stacked, for example, in an order of the piezoelectric layer 11, the inner electrode 12, the piezoelectric layer 11, the inner electrode 13, and the piezoelectric layer 11. One piezoelectric layer 11 is sandwiched by two inner electrodes 12, 13. The two outer electrodes 14, 15 are disposed on the outer surface of the stacked body of the piezoelectric layer 11 and the inner electrodes 12, 13. The outer electrodes 14, 15 are predominantly formed of, for example, Au. Among the two inner electrodes 12, 13 in contact with the one piezoelectric layer 11, an end of the inner electrode 12 is connected to the outer electrode 14, and an end of the inner electrode 13 is connected to the outer electrode 15. Through application of a voltage between the outer electrodes 14, 15, the piezoelectric layer 11 expands and contract, whereby the piezoelectric element 10 in entirety expands and contracts.

An example of the method of producing the piezoelectric element 10 according to embodiment 2 will next be described. First, a plurality of essential ingredients for producing a primary phase are chosen from powder-form raw materials, and weighed so as to attain a target composition. The powder-form raw materials may be an oxide, a carbonate salt, a hydroxide, or the like of an element forming the primary phase. To the thus-weighed powder raw materials, ethanol is added, and the mixture is subjected to wet mixing by means of a ball mill preferably for 15 hours or longer, to thereby yield a slurry. The slurry was dried to form a powder mixture, and the powder is calcined under the conditions, for example, 600 to 1,000°C in air for 1 to 10 hours, to thereby obtain a powder-form primary phase calcined product.

Separately, a plurality of essential ingredients for producing the secondary phase are chosen from powder-form raw materials, and weighed so as to attain a target composition. In this case, a compound containing Mn and a compound containing Sc are used as essential powder-form raw materials. Regarding the powder-form raw material formed of an Sc-containing compound, the amount of addition is adjusted so that the Sc content of the secondary phase is controlled to 0.05 mol% to 5 mol%. Notably, the powder-form raw materials may be an oxide, a carbonate salt, a hydroxide, or the like of an element forming the secondary phase. To the thus-weighed powder-form raw materials, ethanol is added, and the mixture is subjected to wet mixing by means of a ball mill for preferably 15 hours or longer, to thereby prepare a slurry. The thus-prepared slurry is dried, and the dry powder mixture is calcined at, for example, 600 to 1,000°C in air for 1 to 10 hours, to thereby yield a powder-form secondary phase calcined product.

Subsequently, the primary phase calcined product and the secondary phase calcined product are mixed with a dispersant, a binder, and an organic solvent (e.g., toluene), and the mixture is pulverized and mixed, to thereby give a slurry. Then, the thus-obtained slurry is formed into a sheet through a doctor blade method or the like, to thereby produce a ceramic green sheet.

Then, an electrode layer serving as an inner electrode is formed on a surface of the ceramic green sheet by use of a conductive paste for forming an inner electrode through, for example, screen printing. The electrode layer is predominantly formed of a base metal (e.g., nickel (Ni)).

Next, a plurality of ceramic green sheets each provided with an electrode layer are stacked such that the electrode layers are exposed in an alternating manner, and ceramic green sheets each provided with no electrode layer are stacked on each surface of the stacked body. The thus-obtained stacked bodies are press-bonded, to thereby yield a stacked body in which ceramic green sheets and electrode layers have been alternatingly stacked. The resultant stacked body is cut into a shape of interest, and then maintained at a temperature, for example, 200 to 400°C for 2 to 10 hours, to thereby perform debindering.

Next, the debindered stacked body is maintained for firing at a temperature, for example, 1,000 to 1,200°C in a pressure-controlled reducing atmosphere (a pressure controlled to a reduction side from Ni/NO equilibrium oxygen partial pressure by order of 1 or greater) for 2 to 5 hours.

A side surface of the thus-fired stacked body is appropriately polished, and a pair of outer electrodes formed of Au are formed on the side surface of the stacked body through sputtering or a similar technique. The pair of outer electrodes are formed such that they sandwich the stacked body and oppositely face each other. The stacked body equipped with the outer electrodes is subjected to a polarization treatment, to thereby yield the piezoelectric element 10. Thus, there can be yielded the piezoelectric element (a lamination-type piezoelectric element) 10 having a structure in which piezoelectric layers each formed of a lead-free piezoelectric composition and electrodes (inner electrodes) are alternatingly stacked.

Notably, the production methods of embodiments 1 and 2 as described above are a merely an exemplary method, and various other steps and treatment conditions for producing a piezoelectric element may be employed. For example, instead that a calcined product of the primary phase and that of the secondary phase are separately formed in advance, and the two powder products are mixed, followed by firing, raw materials of the primary phase and those of the secondary phase may be mixed at such a ratio that the target compositional proportions of the finally obtained lead-free piezoelectric composition are attained, followed by firing the thus-prepared mixture. However, through the former method (i.e., separately forming a calcined product of the primary phase and that of the secondary phase in advance and mixing the two products), rigorous control of the composition of the primary phase and that of the secondary phase can be easily achieved, whereby the yield of the lead-free piezoelectric composition can be enhanced. The secondary phase may be formed of two crystalline phases. Also, the material used for forming the electrode may be a metal or an alloy such as platinum (Pt), silverpalladium (Ag-Pd), or silver (Ag).

The lead-free piezoelectric composition and the piezoelectric element disclosed in the present specification exhibit excellent piezoelectric characteristic and excellent insulation property at high temperature. Such a lead-free piezoelectric composition and a piezoelectric element find various uses including vibration sensing, pressure sensing, oscillation, and piezoelectric devices. Examples of the possible use include sensors for detecting various vibrations (e.g., a knocking sensor and a combustion pressure sensor); piezoelectric devices such as an oscillator, an actuator, and a filter; high-voltage generators; micro power supplies; driving units; position control systems; vibration dampers; and fluid discharge systems (e.g., a paint ejector and a fuel ejector).

### EXAMPLES

The present invention will next be described in detail by way of example, which should not be construed as limiting the invention thereto.

### [Examples 1 to 9, 11 to 20, and Comparative Examples 1 to 6]

### (Preparation of primary phase calcined product)

K₂CO₃ powder, Na₂CO₃ powder, Nb₂O₅ powder, TiO₂ powder, ZrO₂ powder, MnCO₃ powder, and BaCO₃ powder were provided as raw material powders. These powders were weighed so that the element contents (mol%) were adjusted to the values shown in Table 1. To a mixture of the thus-weighed raw material powders, an appropriate amount of ethanol was added, and the resultant mixture was wet-mixed by means of a ball mill for 15 hours, to thereby prepare a slurry. The slurry was dried to provide a powder-form mixture, and the mixture was calcined in air at 600 to 1,100°C for 1 to 10 hours, to thereby yield a powder-form primary phase calcined product.

### (Preparation of secondary phase calcined product)

MnCO₃ powder, TiO₂ powder, Nb₂O₅ powder, Li₂CO₃ powder, and Sc₂O₃ powder were provided as raw material powders. Essential powder-form raw materials in accordance with the Examples and the like were chosen from the above powder-form raw materials, and these powders were weighed so as to achieve the composition shown in any of Tables 2, 4, and 5 and an Sc content (mol%) corresponding to the composition. To a mixture of the thus-weighed raw material powders, an appropriate amount of ethanol was added, and the resultant mixture was wet-mixed by means of a ball mill for 15 hours, to thereby prepare a slurry. The slurry was dried to provide a powder-form mixture, and the mixture was calcined in air at 600 to 1,100°C for 1 to 10 hours, to thereby yield a powder-form secondary phase calcined product.

### (Fabrication of piezoelectric element)

The primary phase calcined product and the secondary phase calcined product prepared above were mixed with a dispersant, a binder and ethanol, and the mixture was pulverized and mixed, to thereby give a slurry. The thus-obtained slurry was dried, and the product was suitably granulated and monoaxially pressed at 20 MPa, to thereby provide a preliminary compact of a disk shape. The thus-obtained preliminary compact was subjected to a cold isostatic pressing (CIP) treatment at a pressure of 150 MPa, to thereby yield a compact. Notably, the primary phase calcined product and the secondary phase calcined product were mixed so as to adjust the ratio (vol%) of primary phase to secondary phase to 97:3.

The thus-obtained compact was maintained at 200 to 400°C for 2 to 10 hours, to thereby effect debindering. The thus-debindered compact was fired at 1,000 to 1,200°C in a pressure-controlled reducing atmosphere (a pressure controlled to a reduction side from Ni/NO equilibrium oxygen partial pressure by order of 1 or greater) for 2 hours, to thereby form a piezoelectric layer. Notably, the grain sizes of the secondary phase and the like in the piezoelectric layer were adjusted by appropriately tuning the firing temperature. Specifically, the higher the firing temperature, the greater the grain size.

On each surface of the formed piezoelectric layer, an Au electrode was formed through sputtering. Subsequently, the stacked body having the piezoelectric layer equipped with the electrodes was placed in silicone oil at 50°C and subjected to polarization treatment by applying a DC voltage of 5 kV/mm, to thereby generate a voltage characteristic of the piezoelectric layer. Thus, a piezoelectric element was fabricated.

### [Example 10]

Example 10 is directed to a piezoelectric element employing a lead-free piezoelectric composition including two secondary phases (i.e., secondary phases a and b). As mentioned below, the procedure of Example 1 or the like was repeated, except that two secondary phase calcined products were used, to thereby fabricate a piezoelectric element of Example 10.

MnCO₃ powder, TiO₂ powder, Nb₂O₅ powder, and Sc₂O₃ powder were provided as raw material powders. Essential powder-form raw materials of each secondary phase (secondary phase a or b) were chosen from the above powder-form raw materials, and these powders were weighed so as to achieve the composition shown in Table 3 and an Sc content (mol%) shown in Table 3. The thus-weighed two powder-form raw material mixtures of the secondary phases (secondary phases a and b) was subjected to the production method of Example 1 or the like, to thereby yield two powder-form secondary phase calcined products.

Notably, in production of the piezoelectric layer of the piezoelectric element, proportions in mixing of the primary phase calcined product, a secondary phase calcined product for forming one secondary phase (secondary phase a), and another secondary phase calcined product for forming the other secondary phase (secondary phase b) in the lead-free piezoelectric composition were adjusted to (primary phase):(secondary phase a):(secondary phase b) (vol%) of 97:1.5:1.5.

### [Piezoelectric constant d₃₃]

The piezoelectric constant (pC/N) of each of the piezoelectric elements (piezoelectric layers) of the Examples and the Comparative Examples was measured by means of a d₃₃ meter (ZJ-4B, product of Institute of Acoustics, Chinese Academy of Sciences). Tables 2 to 5 show the results.

### [Insulation resistance at high temperature]

The insulation resistance (Ω·m) at high temperature of each of the voltage elements of the Examples and the Comparative Examples was determined through the following procedure. Specifically, the voltage element was placed in silicone oil at 100°C, and a DC voltage (5 kV/mm) was applied for 1 minute. The insulation resistance (Ω·m) measured at the timing was employed. Tables 2 to 5 show the results.

### [Analysis of primary phase]

Primary phase composition analysis of each of the voltage elements (piezoelectric layers) of the Examples and the Comparative Examples was performed by means of an electron probe microanalyzer (EPMA) through the following procedure. Specifically, the piezoelectric layer of the piezoelectric element was cut along the thickness direction, and the cut surface was polished. The polished surface was observed by means of an EPMA at a magnification of 5,000, and an image was taken. In the obtained image, three crystal grains in the primary phase were selected at random, and the selected three crystal grains were quantitatively analyzed. The element contents at three crystal grains were averaged, and the average value was employed as the element content (mol%). Table 1 shows the results.

### [Analysis of secondary phase]

The aforementioned polished surface of each of the Examples and the Comparative Examples was analyzed through powder X-ray diffractometry (XRD: X-ray diffraction), to thereby identify the composition of a compound included in the secondary phase. Conditions for XRD measurement are as follows.

### <XRD measurement conditions>

Apparatus: powder X-ray diffractometer
Range: 50.00° to 70.00°
Wavelength: 0.7 angstroms

In addition, the secondary phase qualitative analysis of each of the voltage elements (piezoelectric layers) of the Examples and the Comparative Examples was performed by means of an electron probe microanalyzer (EPMA) through the following procedure. In each Example, the same polished surface of the piezoelectric layer as observed for the primary phase analysis was also observed by means of an EPMA at a magnification of 5,000, and an image was taken. The obtained image was subjected to element mapping in terms of Sc (scandium). From the obtained element mapping image, the presence of Sc in the secondary phase was confirmed. In each of Examples 1 to 20, the presence of Sc was confirmed in the secondary phase. In Comparative Examples 4 and 5, the presence of Sc was also confirmed in the secondary phase. However, the presence of Sc was not confirmed in the secondary phase in Comparative Examples 1 to 3, and 6.

### [Grain sizes (maximum grain size, mean grain size, and D80) of crystal grains of secondary phase]

The aforementioned polished surface of each of the Examples 5, and 14 to 20, and Comparative Example 6 was observed under a scanning electron microscope (SEM) at a magnification of 5,000, and an image was taken. In the obtained SEM image (i.e., reflected electron image), a square (250 µm × 250 µm) for measurement was placed. A plurality of crystal grains present in the measurement square were analyzed by image analysis software, to thereby determine a long-axis diameter and a short-axis diameter. In one crystal grain, the long-axis diameter and the short-axis diameter cross at right angle. The values of long-axis diameter and short-axis diameter are the maximum values along the corresponding axis. The average value of the long-axis diameter and short-axis diameter of the crystal grain was employed as a grain size of each crystal grain. The thus-obtained average grain size of the crystal grain falling within the aforementioned measurement range was employed as a mean grain size (µm) of the crystal grains of the secondary phase. Table 5 shows the results.

Also, among the crystal grains observed within the aforementioned measurement range, the largest long-axis diameter was employed as the maximum grain size (µm) of the crystal grain in the secondary phase. Table 5 shows the results.

In addition, regarding the crystal grains observed within the aforementioned measurement range, a grain size distribution from the small size was drawn. On the basis of the grain size distribution, the number-basis 80% cumulative particle size (D80) was determined. Table 5 shows the results.

**[Table 1]**

| Primary Phase | | | | | | | |
|---|---|---|---|---|---|---|---|
| Element | A1 | | M1 | Nb | Mn | Ti | Zr |
| | K | Na | Ba | | | | |
| Coefficient | a | | b | d | | | |
| | a1 | a2 | b3 | d1 | d2 | d3 | d4 |
| | 0.467 | 0.517 | 0.016 | 0.956 | 0.014 | 0.014 | 0.018 |
| Content (mol%) | 23.7 | 26.2 | 0.8 | 47.1 | 0.7 | 0.7 | 0.8 |

**[Table 2]**

| | Secondary phase | | Insulation resistance ( Ω·m) | Piezoelectric constant d₃₃ (pC/N) |
|---|---|---|---|---|
| | Composition | Sc (mol%) | | |
| Comp. 1 | MnTi₂O₄ | 0 | 5×10⁵ | 120 |
| Comp. 2 | Mn₄Nb₂O₉ | 0 | 1×10⁶ | 115 |
| Comp. 3 | LiTiO₄ | 0 | 4×10⁴ | 126 |
| Ex. 1 | MnTi₂O₄ | 0.1 | 2×10¹⁰ | 118 |
| Ex. 2 | Mn₄Nb₂O₉ | 0.1 | 1×10¹⁰ | 125 |
| Comp. 4 | LiTiO₄ | 0.1 | 2×10⁵ | 118 |
| Ex. 3 | MnTi₂O₄ | 0.05 | 3×10¹⁰ | 118 |
| Ex. 4 | MnTi₂O₄ | 0.3 | 1×10¹⁰ | 113 |
| Ex. 5 | MnTi₂O₄ | 1 | 1×10¹⁰ | 124 |
| Ex. 6 | MnTi₂O₄ | 3 | 8×10⁹ | 117 |
| Ex. 7 | MnTi₂O₄ | 5 | 6×10⁹ | 114 |
| Comp. 5 | MnTi₂O₄ | 7 | unmeasurable | unmeasurable |
| Ex. 8 | Mn₄Nb₂O₉ | 0.05 | 2×10¹⁰ | 121 |
| Ex. 9 | Mn₄Nb₂O₉ | 3 | 1×10¹⁰ | 116 |

**[Table 3]**

| | | | | | | |
|---|---|---|---|---|---|---|
| | Secondary phase a | | Secondary phase b | | Insulation resistance ( Ω·m) | Piezoelectric constant d₃₃ (pC/N) |

| | Composition | Sc (mol%) | Composition | Sc (mol%) | | |
|---|---|---|---|---|---|---|
| Ex. 10 | Mn₄Nb₂O₉ | 0.1 | MnTi₂O₄ | 0.1 | 1×10¹⁰ | 130 |

**[Table 4]**

| | Secondary phase | | Insulation resistance ( Ω·m) | Piezoelectric constant d₃₃ (pC/N) |
|---|---|---|---|---|
| | Composition | Sc (mol%) | | |
| Ex. 5 | MnTi₂O₄ | 1 | 1×10¹⁰ | 124 |
| Ex. 11 | Mn₂TiO₄ | 0.05 | 1×10¹⁰ | 118 |
| Ex. 12 | Mn₂TiO₄ | 1 | 2×10¹⁰ | 121 |
| Ex. 13 | Mn₂TiO₄ | 3 | 7×10⁹ | 118 |

**[Table 5]**

| | Secondary phase | | Insulation resistance ( Ω·m) | Piezoelectric constant d₃₃ (pC/N) | Max. grains size (µm) | D80 (µm) | Mean grain size (µm) |
|---|---|---|---|---|---|---|---|
| | Composition | Sc (mol%) | | | | | |
| Ex. 14 | MnTi₂O₄ | 1 | 4×10¹⁰ | 125 | 0.8 | 0.6 | 0.4 |
| Ex. 15 | MnTi₂O₄ | 1 | 2×10¹⁰ | 124 | 15 | 12 | 9 |
| Ex. 5 | MnTi₂O₄ | 1 | 1×10¹⁰ | 124 | 40 | 32 | 21 |
| Ex. 16 | MnTi₂O₄ | 1 | 8×10⁹ | 122 | 52 | 46 | 38 |
| Ex. 17 | MnTi₂O₄ | 1 | 4×10⁹ | 124 | 58 | 54 | 41 |
| Ex. 18 | MnTi₂O₄ | 1 | 3×10⁹ | 118 | 67 | 60 | 48 |
| Ex. 19 | MnTi₂O₄ | 1 | 1×10⁹ | 118 | 94 | 83 | 65 |
| Ex. 20 | MnTi₂O₄ | 1 | 7×10⁸ | 118 | 126 | 115 | 89 |
| Comp. 6 | MnTi₂O₄ | 0 | 1×10⁶ | 107 | 51 | 40 | 35 |

As is clear from Tables 2 and 3, the lead-free piezoelectric compositions employed in the piezoelectric elements of Examples 1 to 10 each have a secondary phase formed of an Mn oxide (MnTi₂O₄ or Mn₄Nb₂O₉ or both). In Examples 1 to 10, the Mn oxide contains Sc in an amount of 0.05 mol% or more and 5 mol% or less. In Examples 1 to 10, the insulation resistance at high temperature was 1 × 10¹⁰ Ω·m or higher. Thus, excellent insulation property at high temperature has been confirmed.

Comparative Example 1 corresponds to a piezoelectric element having a secondary phase containing MnTi₂O₄ but no Sc (scandium). In Comparative Example 1, the insulation resistance at high temperature was 5 × 10⁵ Ω·m. Thus, insufficient insulation property at high temperature has been confirmed.

Comparative Example 2 corresponds to a piezoelectric element having a secondary phase containing Mn₄Nb₂O₉ but no Sc (scandium). In Comparative Example 2, the insulation resistance at high temperature was 5 × 10⁶ Ω·m. Thus, insufficient insulation property at high temperature has been confirmed.

Comparative Example 3 corresponds to a piezoelectric element having a secondary phase containing LiTiO₄, which is not an Mn oxide. Also, the secondary phase contains no Sc (scandium). In Comparative Example 3, the insulation resistance at high temperature was 4 × 10⁴ Ω·m. Thus, insufficient insulation property at high temperature has been confirmed.

Comparative Example 4 corresponds to a piezoelectric element having a secondary phase containing LiTiO₄, which is not an Mn oxide. Also, the secondary phase contains Sc (scandium) in an amount of 0.1 mol%. In Comparative Example 4, the insulation resistance at high temperature was 2 × 10⁵ Ω·m. Thus, insufficient insulation property at high temperature has been confirmed.

Comparative Example 5 corresponds to a piezoelectric element having a secondary phase containing the same Mn oxide as employed in Example 1 or the like. Also, the secondary phase contains Sc (scandium) in an excessive amount. In Comparative Example 5, the insulation resistance was not successfully measured. Thus, poor insulation property at high temperature has been confirmed.

As shown in Tables 2 and 3, the piezoelectric constant d₃₃ measurements in Examples 1 to 10 have revealed excellent piezoelectric characteristics.

As shown in Tables 4 and 5, the lead-free piezoelectric compositions employed in the piezoelectric elements of Examples 11 to 20 each have a secondary phase containing an Mn oxide (Mn₂TiO₄). In Examples 11 to 20, the Mn oxide contains Sc in an amount of 0.05 mol% or more and 3 mol% or less. In Examples 11 to 20, the insulation resistance at high temperature was 7 × 10⁸ Ω·m or higher. Thus, excellent insulation property at high temperature has been confirmed. Also, as shown in Tables 4 and 5, the piezoelectric constant d₃₃ measurements in Examples 11 to 20 have revealed excellent piezoelectric characteristics.

Comparative Example 6 corresponds to a case in which an Mn oxide (Mn₂TiO₄) contains no Sc. In Comparative Example 6, piezoelectric characteristics and insulation property were problematic.

As shown in Table 4, when the secondary phase contains Mn₂TiO₄ as the Mn oxide, the insulation property is further enhanced when the Mn oxide contains Sc in an amount of 0.05 mol% or more and 1 mol% or less.

Also, as shown in Table 5, when the crystal grains of the secondary phase have a maximum grain size of 94 µm or less (or D80 of the crystal grains of the secondary phase is 83 µm or less, or the mean grain size of the crystal grains of the secondary phase is 65 µm or less), the insulation property is further enhanced.

### REFERENCE SIGNS LIST

10, 200: piezoelectric element
11, 100: piezoelectric layer (piezoelectric ceramic layer)
12, 13: inner electrode
14, 15: outer electrode
301, 302: electrode

## Claims

1. A lead-free piezoelectric composition comprising
a primary phase containing an alkali niobate perovskite-type oxide, and
a secondary phase containing an Mn oxide, wherein
the Mn oxide contains Sc in an amount of 0.05 mol% or more and 5 mol% or less.

2. A lead-free piezoelectric composition according to claim 1,
wherein the Mn oxide includes at least one species of Mn₄Nb₂O₉, MnTi₂O₄, and Mn₂TiO₄.

3. A lead-free piezoelectric composition according to claim 1 or 2, wherein crystal grains of the secondary phase has a maximum mean grain size of 94 µm or smaller.

4. A piezoelectric element having a structure in which a lead-free piezoelectric composition as recited in any one of claims 1 to 3, and an electrode are alternatingly stacked.
